(19) Europäisches Patentamt

European Patent Office

Office européen des brevets

(11) **EP 2 613 440 B1**

(12) **EUROPEAN PATENT SPECIFICATION**

(45) Date of publication and mention
of the grant of the patent:
**10.07.2019 Bulletin 2019/28**

(51) Int Cl.:
***H03H 9/215*** *(2006.01)*

(21) Application number: **12150490.6**

(22) Date of filing: **09.01.2012**

(54) **Small-sized piezoelectric tuning-fork resonator**

Kleiner piezolektrischer Stimmgabelresonator

Résonateur de diapason piézoélectrique de petite taille

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**10.07.2013 Bulletin 2013/28**

(73) Proprietor: **Micro Crystal AG
2540 Grenchen (CH)**

(72) Inventors:
• **Staub, Felix
3425 Koppigen (CH)**
• **Dalla Piazza, Silvio
2610 St-Imier (CH)**

(74) Representative: **Giraud, Eric et al
ICB
Ingénieurs Conseils en Brevets SA
Faubourg de l'Hôpital 3
2001 Neuchâtel (CH)**

(56) References cited:
**JP-A- 6 112 761        JP-A- 2008 199 283
JP-A- 2009 206 759        US-A1- 2003 067 248
US-A1- 2006 279 176        US-A1- 2011 187 470
US-B1- 7 138 752**

**Description**

FIELD OF THE INVENTION

The present invention concerns piezoelectric tuning-fork resonators and more particularly tuning-fork resonators of small dimensions which are most often used for making frequency generators for portable electronic equipment, in numerous fields such as horology, information technology, telecommunications and the medical field.

BACKGROUND OF THE INVENTION

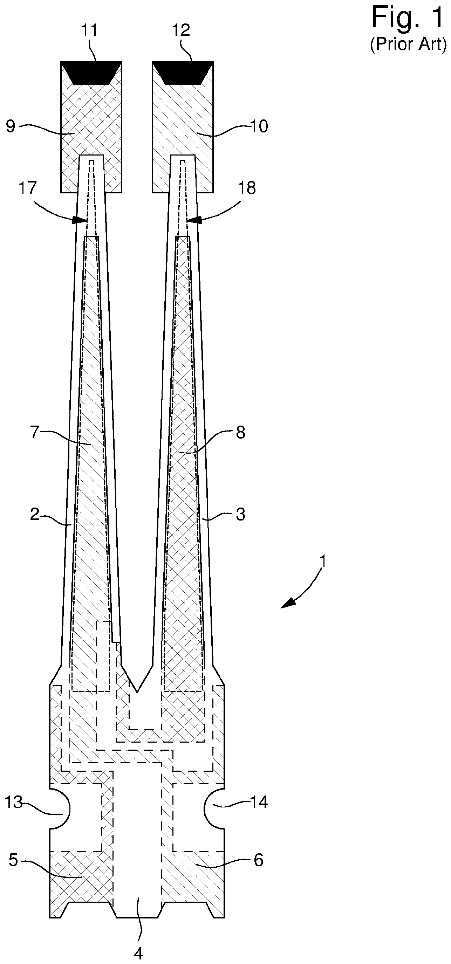

A piezoelectric resonator of this type with small dimensions has already been disclosed in the prior art document U.S. Pat. No. 7,626,318. . The appended figure 1 is a reproduction of the figure 1 of this prior art document. Referring to this figure, one can see that the depicted tuning-fork resonator 1 is formed of a base 4 and two vibrating arms 2, 3 extending from the base. In a known manner, each arm carries metalized portions 5, 6 that form central electrodes on the main opposite surfaces and lateral electrodes along the sides of each arm. The central electrodes on one arm are connected to the lateral electrodes on the other arm and to one terminal of an oscillator circuit. The other central and lateral electrodes are connected in an identical manner to the other terminal of the oscillator circuit. The oscillator circuit is an electrical circuit arranged to subject the electrodes to an oscillating electric current that causes the arms to vibrate at a desired fundamental frequency.

Grooves 7, 8 are provided in each arm. The arrangement of the central electrodes inside the grooves, in the thickness of the arms, increases piezoelectric coupling. For a resonator having the same dimensions, the increase of the coupling causes a decrease in the equivalent resistance for a given resonator quality factor and consequently a decrease in the power consumption thereof. Conversely, for the same equivalent resistance, the presence of the grooves allows a reduction in the dimensions of the resonator. In substance, the use of grooves makes it possible to produce highly miniaturized resonators with the same given resonant frequency.

There is however a limit to miniaturization. Indeed, theory shows that, if the length of the vibrating arms is L and the width of the arms is W, the fundamental resonant frequency tends to behave like $\dfrac{W}{L^2}$ . It follows that, for a given resonant frequency, the shorter the length of an arm is, the narrower its width must be. A consequence is that, below a certain dimension, the vibrating arms must be made so narrow that the reduction in the volume of the elastically active piezoelectric material is associated with an unacceptable decrease in the quality factor. Notwithstanding, in order to attain a higher degree of miniaturization, the above-mentioned prior art document further teaches that the vibrating arms each end in an enlarged portion called a flipper 9, 10. The flippers have the effect of lowering the frequency for a given length, and thus allow having shorter vibrating arms for the same given frequency.

We can cite the patent applications US 2003/0067248 A1 and US 2006/0279176 A1, and the patent US 7,138,752 B1, which describe a small-sized piezoelectric resonator. The resonator includes also a base with a central arm to be fixed on a support, and two vibrating arms extending from the base. In the patent application US 2011/0187470 A1, the resonator includes a base with several vibrating arms extending from the base. However the embodiments of said resonator have the same drawbacks of the above-mentioned resonator shown in Figure 1.

We can cite also the patent documents JP 2008-199283 A, JP 06-112761 A and JP 2009-206759 A, which describe a piezoelectric vibrating piece. The vibrating piece includes a base, and two arms extending from the base. Each U-shaped arm is formed of a first arm part and a second arm part, which is connected by a cross portion to the first arm part. A first excitation electrode is placed on upper and lower main surfaces of the first arm, whereas a second excitation electrode is placed on lateral surfaces of the first arm. The second excitation electrode is also placed on upper and lower main surfaces of the second arm, whereas the first excitation electrode is placed on lateral surfaces of the second arm. A drawback is that the first and second arm parts oscillate with the same phase, and the oscillation does not correspond to the fundamental frequency but to an overtone.

It is an object of the present invention to provide a piezoelectric resonator compatible with a higher degree of miniaturization than prior art resonators, without overly reducing the quality factor or increasing the equivalent resistance.

SUMMARY OF THE INVENTION

The present invention achieves the object cited above by providing a piezoelectric tuning-fork resonator in accordance with the annexed claim 1.

According to the invention, the piezoelectric resonator is intended to be mounted on a support via the linking part. This arrangement implies that the tuning-fork shaped parts are both held by the tip of one of their vibrating arms. This is in contrast with the standard case, according to which a single tuning-fork is normally held via the cross portion, in the middle. Furthermore, as the two vibrating arms of each tuning-fork shaped part vibrate with opposite phase, when the two vibrating arms of the same tuning fork shaped part are bending, the individual contributions of the two arms to the total displacement add up. In practice, this means that during one oscillation, the tip of the vibrating arm that is not held travels roughly twice as far as it would if the tuning fork had been held in the usual manner; by the cross portion. In other words, when it is held by the tip of one arm, each tuning fork shaped part behaves in a similar fashion to a single vibrating arm roughly twice as long. This feature contrasts with the well known case of a tuning-fork held in the middle, in which the individual contributions of the two arms compensate each other.

Therefore, an advantage of the present invention is that the arms of the tuning fork shaped parts can be made roughly twice as short for the same resonant frequency. This can translate into a substantial reduction in the length of a resonator.

BRIEF DESCRIPTION OF THE DRAWINGS

Other features and advantages of the present invention will appear upon reading the following description, given solely by way of non-limiting example, and made with reference to the annexed drawings, in which:

- figure 1 shows a prior art piezoelectric tuning-fork resonator;
- figure 2 is a planar view of a piezoelectric tuning-fork resonator according to a particular embodiment of the invention;
- figure 3a and 3b are top and bottom views respectively of the piezoelectric tuning-fork resonator of figure 2, showing the metalized portions which form two groups of electrodes;
- figure 4 is a perspective view of a median longitudinal cross-section of the resonator of figure 2, the resonator being mounted in a case.

DETAILED DESCRIPTION OF THE INVENTION

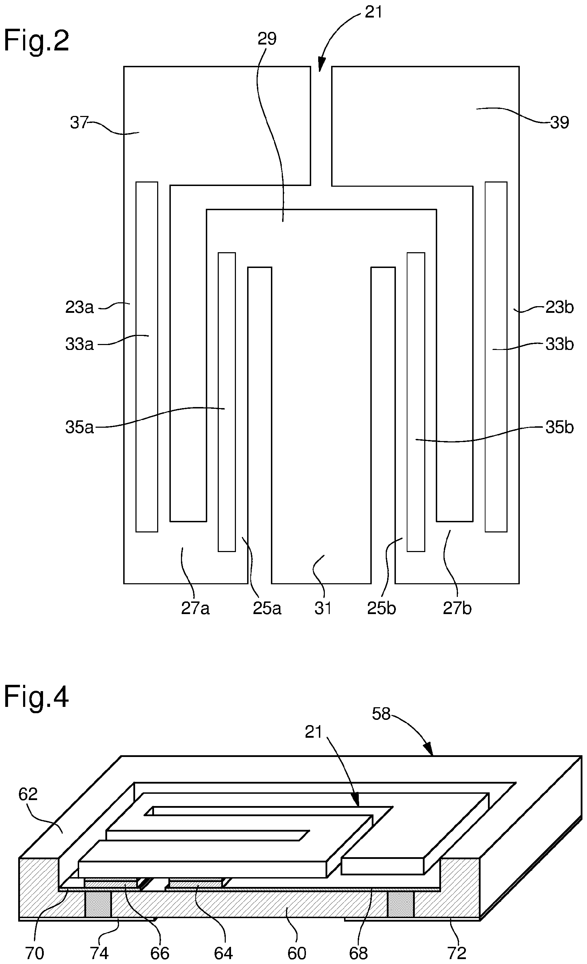

An exemplary embodiment of the invention will be described bellow with reference to Figures 2, 3a, 3b and 4. The piezoelectric tuning-fork resonator, designated by the general reference 21, includes a first and a second planar tuning-fork shaped part. Each tuning-fork shaped part comprises two vibrating arms extending substantially in the same direction from a cross portion. Referring to figure 2 in particular, one can observe that the vibrating arms of one tuning-fork shaped part are referenced 23a and 25a, the vibrating arms of the other tuning-fork shaped part are referenced 23b and 25b, and the cross portions of the two tuning-fork shaped parts are referenced 27a and 27b respectively. As further shown in figure 2, the two tuning-fork shaped parts are arranged side by side in the same plane. In the present example, the tuning-fork shaped parts are arranged symmetrically and parallel to each other. Furthermore, the resonator of the present example is made out of a single piece of piezoelectric material, preferably quartz. It should be understood however that, according to other embodiments, the assembly could alternatively be made out of a non-piezoelectric material, silicon for example, and be coated with a piezoelectric thin film.

According to the invention, the first and the second tuning-fork shaped parts are linked together by linking part 29. Referring again to figure 2, one can see that, in the depicted example, the tuning-fork shaped parts are arranged on either side of the axis of symmetry of the drawing and that the linking part, which is located in the center, spans the axis of symmetry. The linking part extends between the tip of a vibrating arm 25a on one side of the axis of symmetry and the tip of a vibrating arm 25b on the other side. The vibrating arms 25a and 25b will be called hereafter the inner vibrating arms, and the other vibrating arms (referenced 23a and 23b) will be called the outer vibrating arms. In the present example, the resonator 21 further comprises a central arm 31 located between the inner vibrating arms. The central arm extends from the linking part 29, in the plane of the vibrating arms, substantially equidistant from the inner vibrating arms. According to the depicted embodiment, the length of the central arm is chosen so that the distal end of the central arm is on a line with the two cross portions 27a and 27b. It should be understood however that alternative embodiments of the resonator could have a longer, or preferably a shorter, central arm. One will also observe that the central arm shown in the figures is wider than the vibrating arms. Indeed, the width of the central arm is preferably at least twice the width of a vibrating arm.

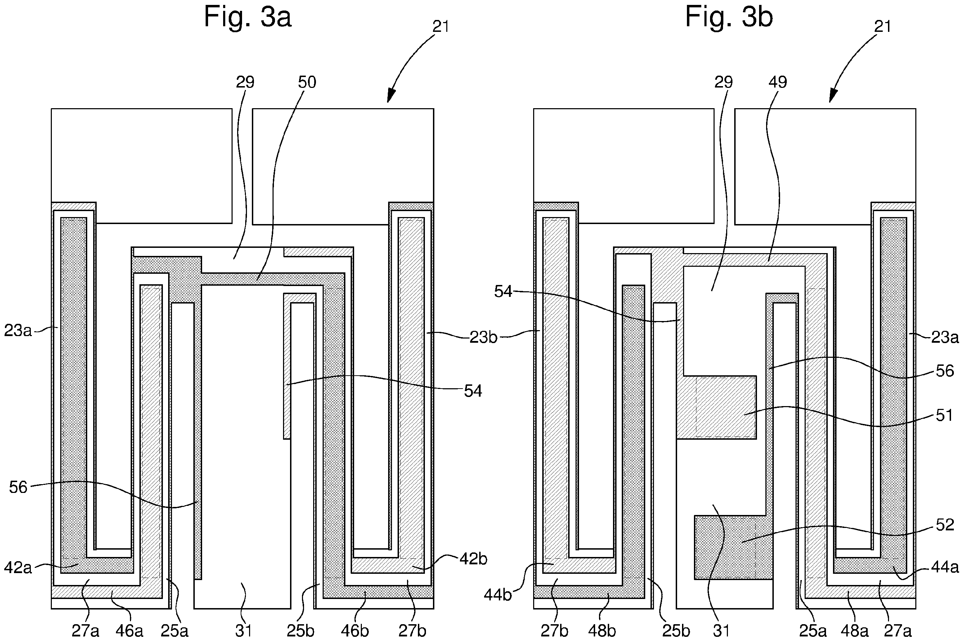

Grooves 33a, 33b, 35a, 35b are formed in at least one of the upper and lower main surfaces of each vibrating arm. Figure 2 shows that the grooves each start inside one of the cross portions 27a and 27b and extend along the full length of an arm. As shown in figures 3a and 3b, the tuning-fork shaped parts and the linking part 29 further carry metalized portions, i.e. conductive depositions, which form two groups of electrodes similar to those of the resonator of figure 1. These two groups of electrodes enable the piezoelectric material of the arms 23a, 23b, 25a, 25b to be subjected to electric fields in order to make the arms vibrate at a desired frequency called the fundamental frequency. Both groups of electrodes comprise central electrodes formed inside the grooves of the top and bottom main surfaces of the arms, as well as lateral electrodes along the sides of the arms. Still referring to figures 3a and 3b, one will understand that the metalized depositions formed on cross portions 27a, 27b and on the linking part 29 serve to connect the central electrodes located on one arm to the lateral electrodes located on another arm, and vice versa. More specifically, the conductive paths 42a, 44a formed on the cross portion 27a of a particular tuning-fork shaped part (referred to as tuning-fork shaped part "a") connect the central electrodes disposed on the outer vibrating arm 23a of the tuning-fork shaped part to the lateral electrodes disposed on the inner vibrating arm 25a of the tuning-fork shaped part. Conversely, the conductive paths 46a, 48a on the cross portion 27a connect the lateral electrodes disposed on the outer vibrating arm 23a to the central electrodes disposed on the inner vibrating arm 25a. In an identical manner, conductive paths 42b, 44b, 46b, 48b on formed on the cross portion 27b of the other tuning-fork shaped part connect central and lateral electrodes disposed on the vibrating arms of tuning-fork shaped part "b".

Still referring to figures 3a and 3b, one will note that the linking part 29 carries conductive paths 50 and 49 visible on its top and bottom sides respectively. One will understand that one of these two conductive paths serves to connect the central electrodes on the inner vibrating arm of one tuning fork shaped part to the lateral electrodes on the inner vibrating arm of the other tuning fork shaped part. And that, in an identical manner, the other conductive path serves to connect the other central and lateral electrodes located on the inner vibrating arms. Figure 3b further shows that the central arm carries two conductive connection pads 51, 52 on its bottom side. The connection pads 51, 52 are each connected to a group of electrodes by a conductive path (referenced 54 and 56 respectively). More specifically, conductive path 54 connects connection pad 51 to conductive path 49, and conductive path 56 connects connection pad 52 to conductive path 50.

The electrodes and conductive paths just described are arranged to make the arms 23a, 23b, 25a, 25b vibrate in flexural mode. However, they could alternatively have been arranged in a different configuration adapted to make the arms vibrate in the same mode or in another mode (torsion, shearing, etc).

Figure 4 is a perspective view of a median longitudinal cross-section of the resonator of figure 2. Figure 4 shows how the resonator can be mounted in a case. The case (referenced 58) has a rectangular shape, only half of which is shown. It includes a main part formed by a flat bottom 60 and four sides 62, and a cover (not shown). The cover is designed to be vacuum soldered onto the main part after the resonator 21 has been mounted inside the case (58). The mounting of the resonator inside the case is achieved by soldering or gluing its connection pads 51, 52 onto respective conductive studs 64, 66 formed on the bottom 60 of the case. Still referring to figure 4, one can observe that the studs 64, 66 are electrically connected to external contact pads 72, 74 of the case by means of inner paths 68, 70 formed on the flat bottom 60. One will understand from the above description that, according to the present example, the flat bottom of the case serves as a support onto which the resonator is mounted.

According to the described example, studs 64, 66 are gold bumps. However, it should be understood that the studs could be made differently. For example, these studs could be formed by small ceramic parts glued onto the flat bottom 60. In this case, connection pads 51, 52 of the resonator could then be glued onto these ceramic parts with a conductive adhesive, which would at least partly encapsulates the ceramic parts in order to assure electric connection between the pads 51, 52 located on top of the ceramic parts and the inner paths 68, 70 located at the base of the ceramic parts.

It should also be noted that the length of a resonator like resonator 21 is not only considerably shorter than the length of a resonator like the one illustrated in figure 1. The ratio between the length and the width of the resonator is also better suited for mounting the resonator in an SMD type case. This ratio can even be calculated such that the resonator can be mounted in a case of square shape, to facilitate manufacture of the said case, and by selecting a suitable arrangement for studs 64, 66 and pads 51, 52, for example an L configuration, and by disposing them properly, for example such that the Ls form a square, it is possible to place the resonator in the case in four different positions. This feature can facilitate the automatic mounting of the resonator.

**Claims**

1. A piezoelectric resonator (21) suitable to be mounted on a support (60), including a first planar tuning-fork shaped part and a second planar tuning-fork shaped part arranged side by side in a common plane, and further including a linking part (29) arranged to link the first and second tuning-fork shaped parts together, the first and the second tuning-fork shaped parts each having an inner vibrating arm (25a, 25b) with a first end linked to the linking part (29), an outer vibrating arm (23a, 23b) with a first end free to move, and a cross portion (27a, 27b) linked to a second end of the inner vibrating arm and a second end of the outer vibrating arm, the inner and the outer vibrating arms of each tuning-fork shaped part extending from the respective cross portion, substantially parallel to each other, and carrying electrodes arranged to make the inner and the outer vibrating arms oscillate, the electrodes being connected to connection pads (51, 52), the inner vibrating arm (25a) of the first tuning-fork shaped part and the inner vibrating arm (25b) of the second tuning-fork shaped part further being arranged side by side, substantially parallel to each other and on either side of an axis of symmetry with the linking part (29) located in the center, the linking part (29) extending between the first ends of the inner vibrating arms (25a, 25b) so as to join the first ends together, the piezoelectric resonator being suitable to be mounted on the support via the linking part (29), and the electrodes carried by the first and second tuning-fork shaped parts being interconnected through the linking part so as to make the inner vibrating arms of the first and second tuning-fork shaped parts oscillate with opposite phase, when the inner vibrating arms (25a, 25b) are bending,
   **characterized in that** a central arm (31) is attached to the linking part (29) and is located between the inner vibrating arms (25a, 25b), substantially equidistant from these arms, and
   **in that** the electrodes carried by the inner and the outer vibrating arms are interconnected through the cross portions (27a, 27b) of the first and the second tuning-fork shaped parts respectively, in such a way as to make the first end of the outer vibrating arm of each of the tuning-fork shaped parts oscillate with opposite phase to the inner vibrating arm, when the inner and outer vibrating arms of each planar tuning-fork shaped part are bending, and, wherein each of the vibrating arms has an upper main surface and a lower main surface and two side surfaces extending between the upper and the lower main surfaces, wherein the electrodes comprise central electrodes disposed on the upper and lower main surfaces of the vibrating arms, and lateral electrodes disposed on side surfaces of the vibrating arms, wherein the central electrodes disposed on the outer vibrating arm (23a) of the first tuning-fork shaped part are connected to the lateral electrodes disposed on the inner vibrating arm (25a) of the same tuning-fork shaped part, to the central electrodes disposed in the inner vibrating arm (25b) of the second tuning-fork shaped part, and to the lateral electrodes disposed on the outer vibrating arm (23b) of the second tuning-fork shaped part, and wherein the central electrodes disposed on the outer vibrating arm (23b) of the second tuning-fork shaped part are connected to the lateral electrodes disposed on the inner vibrating arm (25b) of the same tuning-fork shaped part, to the central electrodes disposed on the inner vibrating arm (25a) of the first tuning-fork shaped part, and to the lateral electrodes disposed on the outer vibrating arm (23a) of the first tuning-fork shaped part.

2. The piezoelectric resonator of claim 1, wherein it is made out of a single quartz crystal.

3. The piezoelectric resonator of any one of claims 1 and 2, wherein at least one groove (33a, 33b, 35a, 35b) is formed on at least one of the upper and the lower mains surfaces of each vibrating arm.

4. The piezoelectric resonator of claim 3, wherein the depth of said groove is between 15% and 50%, and preferably between 30% and 50%, of the thickness of said vibrating arms in the depth direction.

5. The piezoelectric resonator of claim 1, wherein the connection pads (51, 52) are carried by the central arm (31).

6. The piezoelectric resonator of claim 5, wherein the central arm (31) is at least twice as wide as a vibrating arm.

7. The piezoelectric resonator of claim 6, wherein its mounting onto the support (60) is achieved by soldering or gluing the two connection pads (51, 52) onto respective conductive studs (64, 66) formed on a top surface of the support.

8. The piezoelectric resonator of any one of the preceding claims, wherein the outer vibrating arms (23a, 23b) end at their first ends in flippers (37, 39) extending beyond the linking part, the width of the flippers being larger than that of the outer vibrating arms.

**Patentansprüche**

1. Piezoelektrischer Resonator (21), geeignet zur Montage an einem Träger (60), umfassend einen ersten ebenen stimmgabelförmigen Teil und einen zweiten ebenen stimmgabelförmigen Teil, die in einer gemeinsamen Ebene nebeneinander angeordnet sind, und ferner umfassend einen Verbindungsteil (29), der dazu angeordnet ist, den ersten und den zweiten stimmgabelförmigen Teil miteinander zu verbinden, wobei der erste und der zweite stimmgabelförmige Teil jeweils einen inneren Vibrationsarm (25a, 25b), dessen erstes Ende mit dem Verbindungsteil (29) verbunden ist, einen äußeren Vibrationsarm (23a, 23b), dessen erstes Ende frei beweglich ist, und einen Querabschnitt (27a, 27b), der mit einem zweiten Ende des inneren Vibrationsarms und mit einem zweiten Ende des äußeren Vibrationsarms verbunden ist, aufweisen, wobei sich der innere und der äußere Vibrationsarm jedes stimmgabelförmigen Teils von dem jeweiligen Querabschnitt im Wesentlichen zueinander parallel erstrecken und Elektroden tragen, die dazu angeordnet sind, den inneren und den äußeren Vibrationsarm schwingen zu lassen, wobei die Elektroden mit Anschlusspads (51, 52) verbunden sind, der innere Vibrationsarm (25a) des ersten stimmgabelförmigen Teils und der innere Vibrationsarm (25b) des zweiten stimmgabelförmigen Teils ferner nebeneinander im Wesentlichen parallel zueinander auf beiden Seiten einer Symmetrieachse mit dem Verbindungsteil (29) in der Mitte angeordnet sind, wobei sich der Verbindungsteil (29) zwischen den ersten Enden der inneren Vibrationsarme (25a, 25b) erstreckt, um die ersten Enden miteinander zu verbinden, wobei der piezoelektrische Resonator an dem Träger über den Verbindungsteil (29) montierbar ist und die durch den ersten und den zweiten stimmgabelförmigen Teil getragenen Elektroden über den Verbindungsteil miteinander verbunden sind, damit die inneren Vibrationsarme des ersten und des zweiten stimmgabelförmigen Teils mit entgegengesetzter Phase schwingen, wenn sich die inneren Vibrationsarme (25a, 25b) biegen,
**dadurch gekennzeichnet, dass** an dem Verbindungsteil (29) ein Mittelarm (31) befestigt ist und sich zwischen den inneren Vibrationsarmen (25a, 25b) im Wesentlichen im gleichen Abstand von diesen Armen befindet und
dass die von den inneren und den äußeren Vibrationsarmen getragenen Elektroden über die Querabschnitte (27a, 27b) des ersten bzw. des zweiten stimmgabelförmigen Teils miteinander verbunden sind, derart, dass sie das erste Ende des äußeren Vibrationsarms jedes der stimmgabelförmigen Teile zum Schwingen mit einer zu jener des inneren Vibrationsarms entgegengesetzten Phase bringen, wenn sich die inneren und äußeren Vibrationsarme jedes ebenen stimmgabelförmigen Teils biegen, wobei jeder der Vibrationsarme eine obere Hauptfläche und eine untere Hauptfläche und zwei Seitenflächen, die sich zwischen den oberen und unteren Hauptflächen erstrecken, besitzt, wobei die Elektroden zentrale Elektroden, die auf den oberen und unteren Hauptflächen der Vibrationsarme angeordnet sind, und seitliche Elektroden, die auf Seitenflächen der Vibrationsarme angeordnet sind, umfassen, wobei die zentralen Elektroden, die auf dem äußeren Vibrationsarm (23a) des ersten stimmgabelförmigen Teils angeordnet sind, verbunden sind mit den seitlichen Elektroden, die auf dem inneren Vibrationsarm (25a) desselben stimmgabelförmigen Teils angeordnet sind, mit den zentralen Elektroden, die auf dem inneren Vibrationsarm (25b) des zweiten stimmgabelförmigen Teils angeordnet sind, und mit den seitlichen Elektroden, die auf dem äußeren Vibrationsarm (23b) des zweiten stimmgabelförmigen Teils angeordnet sind, und wobei die zentralen Elektroden, die auf dem äußeren Vibrationsarm (23b) des zweiten stimmgabelförmigen Teils angeordnet sind, verbunden sind mit den seitlichen Elektroden, die auf dem inneren Vibrationsarm (25b) des zweiten stimmgabelförmigen Teils angeordnet sind, mit den zentralen Elektroden, die auf dem inneren Vibrationsarm (25a) des ersten stimmgabelförmigen Teils angeordnet sind, und mit den seitlichen Elektroden, die auf dem äußeren Vibrationsarm (23a) des ersten stimmgabelförmigen Teils angeordnet sind.

2. Piezoelektrischer Resonator nach Anspruch 1, wobei er aus einem einzelnen Quarzkristall hergestellt ist.

3. Piezoelektrischer Resonator nach einem der Ansprüche 1 und 2, wobei mindestens eine Nut (33a, 33b, 35a, 35b) auf der oberen und/oder der unteren Hauptfläche jedes Vibrationsarms ausgebildet ist.

4. Piezoelektrischer Resonator nach Anspruch 3, wobei die Tiefe der Nut im Bereich von 15 % bis 50 % und vorzugsweise im Bereich von 30 % bis 50 % der Dicke der Vibrationsarme in Tiefenrichtung beträgt.

5. Piezoelektrischer Resonator nach Anspruch 1, wobei die Anschlusspads (51, 52) von dem Mittelarm (31) getragen werden.

6. Piezoelektrischer Resonator nach Anspruch 5, wobei der Mittelarm (31) mindestens doppelt so breit wie ein Vibrationsarm ist.

7. Piezoelektrischer Resonator nach Anspruch 6, wobei seine Montage an dem Träger (60) durch Löten oder Kleben der zwei Anschlusspads (51, 52) auf jeweilige leitende Stifte (64, 66) erreicht wird, die auf einer oberen Fläche des Trägers ausgebildet sind.

8. Piezoelektrischer Resonator nach einem der vorhergehenden Ansprüche, wobei die äußeren Vibrationsarme (23a, 23b) an ihren ersten Enden in Flossen (37, 39), die sich über den Verbindungsteil hinaus erstrecken, enden, wobei die Breite der Flossen größer als jene der äußeren Vibrationsarme ist.

## Revendications

1. Résonateur piézoélectrique (21) adapté pour être monté sur un support (60), incluant une première partie en forme de diapason plan et une seconde partie en forme de diapason plan agencées côte à côte dans un plan commun, et incluant en outre une partie de liaison (29) agencée pour lier les première et seconde parties en forme de diapason ensemble, les première et seconde parties en forme de diapason ayant chacune un bras vibrant intérieur (25a, 25b) avec une première extrémité liée à la partie de liaison (29), un bras vibrant extérieur (23a, 23b) avec une première extrémité libre pour se déplacer, et une portion transversale (27a, 27b) liée à une seconde extrémité du bras vibrant intérieur et une seconde extrémité du bras vibrant extérieur, les bras vibrants intérieur et extérieur de chaque partie en forme de diapason s'étendant depuis la portion transversale respective, sensiblement en parallèle l'un à l'autre, et portant des électrodes agencées pour amener les bras vibrants intérieur et extérieur à osciller, les électrodes étant connectées à des languettes de connexion (51, 52), le bras vibrant intérieur (25a) de la première partie en forme de diapason et le bras vibrant intérieur (25b) de la seconde partie en forme de diapason étant en outre agencés côte à côte, sensiblement en parallèle l'un à l'autre et de chaque côté d'un axe de symétrie avec la partie de liaison (29) située au centre, la partie de liaison (29) s'étendant entre les premières extrémités des bras vibrants intérieurs (25a, 25b) de façon à joindre les premières extrémités ensemble, le résonateur piézoélectrique étant adapté pour être monté sur le support via la partie de liaison (29), et des électrodes portées par les première et seconde parties en forme de diapason étant reliées par la partie de liaison de façon à amener les bras vibrants intérieurs des première et seconde parties en forme de diapason à osciller avec une phase opposée, lorsque les bras vibrants intérieurs (25a, 25b) se plient,
caractérisé en ce qu'un bras central (31) est fixé à la partie de liaison (29) et est situé entre les bras vibrants intérieurs (25a, 25b), sensiblement à équidistance de ces bras, et

**en ce que** les électrodes portées par les bras vibrants intérieur et extérieur sont reliées par les portions transversales (27a, 27b) des première et seconde parties en forme de diapason respectivement, de manière à amener la première extrémité du bras vibrant extérieur de chacune des parties en forme de diapason à osciller avec une phase opposée au bras vibrant intérieur, lorsque les bras vibrants intérieur et extérieur de chaque partie en forme de diapason plan se plient, et dans lequel chacun des bras vibrants a une surface principale supérieure et une surface principale inférieure et deux surfaces de côté s'étendant entre les surfaces principales supérieure et inférieure, dans lequel les électrodes comprennent des électrodes centrales disposées sur les surfaces principales supérieure et inférieure des bras vibrants, et des électrodes latérales disposées sur des surfaces de côté des bras vibrants, dans lequel les électrodes centrales disposées sur le bras vibrant extérieur (23a) de la première partie en forme de diapason sont connectées aux électrodes latérales disposées sur le bras vibrant intérieur (25a) de la même partie en forme de diapason, aux électrodes centrales disposées dans le bras vibrant intérieur (25b) de la seconde partie en forme de diapason, et aux électrodes latérales disposées sur le bras vibrant extérieur (23b) de la seconde partie en forme de diapason, et dans lequel les électrodes centrales disposées sur le bras vibrant extérieur (23b) de la seconde partie en forme de diapason sont connectées aux électrodes latérales disposées sur le bras vibrant intérieur (25b) de la même partie en forme de diapason, aux électrodes centrales disposées sur le bras vibrant intérieur (25a) de la première partie en forme de diapason et aux électrodes latérales disposées sur le bras vibrant extérieur (23a) de la première partie en forme de diapason.

2. Résonateur piézoélectrique selon la revendication 1, dans lequel il est réalisé en un monocristal de quartz.

3. Résonateur piézoélectrique selon l'une quelconque des revendications 1 et 2, dans lequel au moins une gorge (33a, 33b, 35a, 35b) est formée sur au moins l'une des surfaces principales supérieure et inférieure de chaque bras vibrant.

4. Résonateur piézoélectrique selon la revendication 3, dans lequel la profondeur de ladite gorge est entre 15 % et 50 %, et de préférence entre 30 % et 50 %, de l'épaisseur desdits bras vibrants dans la direction de profondeur.

5. Résonateur piézoélectrique selon la revendication 1, dans lequel les languettes de connexion (51, 52) sont portées par le bras central (31).

6. Résonateur piézoélectrique selon la revendication 5, dans lequel le bras central (31) est au moins deux fois plus large qu'un bras vibrant.

7. Résonateur piézoélectrique selon la revendication 6, dans lequel son montage sur le support (60) est obtenu par brasage ou collage des deux languettes de connexion (51, 52) sur des plots conducteurs (64, 66) respectifs formés sur une surface de dessus du support.

8. Résonateur piézoélectrique selon l'une quelconque des revendications précédentes, dans lequel les bras vibrants extérieurs (23a, 23b) se terminent au niveau de leurs premières extrémités en volets articulés (37, 39) s'étendant au-delà de la partie de liaison, la largeur des volets articulés étant plus grande que celle des bras vibrants extérieurs.

Fig. 1
(Prior Art)

EP 2 613 440 B1

Fig.2

37

29

21

39

23a

33a

35a

23b

33b

35b

27a  25a  31  25b  27b

Fig.4

58

21

62

70  74  66  64  60  68  72

9

Fig. 3b

Fig. 3a

**EP 2 613 440 B1**

**REFERENCES CITED IN THE DESCRIPTION**

**Patent documents cited in the description**

- US 7626318 A
- US 20030067248 A1
- US 20060279176 A1
- US 7138752 B1
- US 20110187470 A1
- JP 2008199283 A
- JP 6112761 A
- JP 2009206759 A